# EUROPÄISCHE PATENTANMELDUNG

(11) **EP 2 645 540 A1**
(43) Veröffentlichungstag der Anmeldung: **02.10.2013**
(21) Anmeldenummer: 12161774.0
(22) Anmeldetag: 28.03.2012
(51) Int. Cl.: H02K 3/40, H01B 3/40, H01B 3/44, H01B 1/24, G03F 7/029, G03F 7/031, G03F 7/038

(54) **Glimmschutzwerkstoff für eine elektrische Maschine**

(71) Anmelder: Siemens Aktiengesellschaft, 80333 München (DE)
(72) Erfinder: Brockschmidt, Mario, 45131 Essen (DE); Kempen, Stefan, 59821 Arnsberg (DE); Pohlmann, Friedhelm, 45355 Essen (DE); Schmidt, Guido, 42799 Leichlingen (DE)

(57) **Zusammenfassung**

Es wird ein Glimmschutzwerkstoff (22) zur besonders rationellen Herstellung einer Glimmschutzschicht (16,17) für eine elektrische Maschine (1) angegeben. Der Glimmschutzwerkstoff (22) enthält ein zunächst fließfähiges Matrixmaterial (23), das in einer Aushärtungsreaktion zu einem Feststoff aushärtbar ist. Der Glimmschutzwerkstoff (22) enthält weiterhin einen fotosensitiven Initiator (24), der durch elektromagnetische Strahlung (26) in einen die Aushärtungsreaktion auslösenden reaktiven Zustand überführbar ist. Zudem enthält der Glimmschutzwerkstoff (22) mindestens einen partikulär vorliegenden, elektrischen leitenden Füllstoff (25).

## Beschreibung

Die Erfindung bezieht sich auf einen Glimmschutzwerkstoff zur Herstellung einer Glimmschutzschicht für eine elektrische Maschine.

Mit dem Begriff "elektrische Maschine" ist allgemein ein Energiewandler bezeichnet, der zwischen elektrischer und mechanischer Energie wandelt, nämlich ein elektrischer Motor oder ein Generator. Eine solche elektrische Maschine umfasst üblicherweise einerseits einen ortsfesten Stator (oder Ständer) sowie einen rotierenden Rotor (oder Läufer). Bei der elektrischen Maschine handelt es sich insbesondere um einen Turbogenerator, welcher in einem Kraftwerk zur Umwandlung von mechanischer in elektrische Energie dient.

Ein Turbogenerator ist derzeit meist als dreisträngige Drehstrom-Synchronmaschine mit einem massiven zwei- oder vierpoligen Läufer realisiert. Der Leistungsbereich eines solchen Turbogenerators reicht typischerweise von ca. 20 MVA bis ca. 2000 MVA.

Der Stator eines üblichen Synchrongenerators umfasst eine Vielzahl von sogenannten Statorwicklungen, in welchen durch induktive Wechselwirkung mit dem rotierenden, mit einem konstanten Strom beaufschlagten Rotor eine Wechselspannung induziert wird. Die Statorwicklungen sind in einem sogenannten Blechpaket aufgenommen. Dieses dient unter anderem zur Führung und Verstärkung des magnetischen Feldes. Zur Verringerung von Verlusten durch Wirbelströme ist das gesamte Blechpaket aus dünnen, gegeneinander isolierten Blechen aufgebaut. Die Statorwicklungen bestehen aus einer Vielzahl von Stäben, deren jeweilige Mittelstücke (der sogenannte "Aktivteil") in Nuten des Blechpakets eingelegt sind. Die einzelnen Stäbe treten am sogenannten "Wickelkopf" evolventenförmig aus den Nuten aus. Dort sind die einzelnen Stäbe zur Statorwicklung verschaltet (d.h. miteinander kontaktiert).

Die im Blechpaket einliegenden Stäbe bzw. Stabbereiche liegen auf hohem elektrischem Potential und sind daher untereinander, sowie gegen das geerdete Blechpaket durch eine Hauptisolierschicht isoliert.

Um bei Betriebsspannungen von einigen kV Teilentladungen zu vermeiden, ist die Hauptisolierschicht üblicherweise mit einer inneren und einer äußeren Leitschicht gegen Hohlräume und Ablösungen abgeschirmt (innere Potentialsteuerung, IPS, bzw. Außenglimmschutz, AGS). Die elektrische Feldstärke wird in der Hauptisolierschicht ausgehend von der IPS in radialer Richtung bis zum AGS abgebaut.

Üblicherweise endet der Außenglimmschutz in dem Austrittsbereich, in dem der jeweilige Stab aus der entsprechenden Nut austritt, während die Hauptisolierschicht außerhalb der Nut weitergeführt wird. Diese Anordnung stellt in Bezug auf die elektrische Festigkeit eine kritische Stelle dar, da sich zwischen der in einem festen Aggregatzustand vorliegenden Hauptisolierschicht und einem umgebenden gasförmigen Fluid (meist Luft oder Wasserstoff) eine Grenzschicht ausbildet.

Durch eine daraus resultierende dielektrische Trennfläche zwischen der Hauptisolierung und dem Fluid entsteht eine typische Gleitanordnung, die neben einer rein radialen Feldkomponente, wie sie im Bereich des Blechpakets vorkommt, zusätzlich eine tangentiale (d.h. innerhalb der Trennfläche, insbesondere aber etwa parallel zur Längserstreckung des Leiters verlaufende) Feldkomponente aufweist.

Aufgrund der geringen elektrischen Festigkeit der Luft, kann es schon bei einer vergleichsweise geringen Spannung zum Einsatz einer Teilentladung, bedingt durch die lokale tangentiale Feldstärkeerhöhung (ca. 0,64 kV/mm bei sauberer Oberfläche) kommen, die sich bei einer weiteren Steigerung der Spannung zu Gleitentladungen entlang der Isolierstoffoberfläche bis zu einem elektrischen Durchschlag (d.h. einem Leiter-Erde-Kurzschluss) ausweiten kann. Diese kritische Belastung tritt vor allem während der Prüfung des Generators auf, da der Generator zu Prüfungszwecken regelmäßig an die Belastungsgrenze gefahren wird. Durch die Ausbildung von Gleitentladungen an der Oberfläche wird der Isolierstoff langfristig zerstört.

In Abwesenheit von Schutzmechanismen tritt die größte Feldstärke dabei am Ende des Außenglimmschutzes auf. Daher ist es normalerweise erforderlich, für eine Feldsteuerung am Ende des Außenglimmschutzes und für eine Festigkeitserhöhung in der Umgebung der freiliegenden Hauptisolierschicht zu sorgen.

Dies wird üblicherweise durch die Herstellung eines sogenannten Endenglimmschutzes erreicht. Dabei werden zur Unterdrückung von Gleitentladungen üblicherweise resistive Potentialsteuerungen durch halbleitende (d.h. schwach leitende) Lacke oder Bänder vorwiegend auf der Basis von Siliziumkarbid oder anderen elektrisch halbleitenden Füllstoffen eingesetzt. Ziel der Potentialsteuerung ist es, den tangentialen Potentialabbau entlang der Isolierstoffoberfläche zu vergleichmäßigen. Hierfür wird ein in axialer Richtung ortsabhängiger und spannungsabhängiger Widerstandsbelag hergestellt.

Sowohl der Außenglimmschutz als auch der Endenglimmschutz werden üblicherweise entweder durch Umwickeln der Hauptisolierschicht mit elektrisch schwach leitenden (AGS) bzw. elektrisch halbleitenden (EGS) Bändern oder durch Aufbringen eines elektrisch leitenden bzw. halbleitenden Lackes realisiert. Bezüglich des EGS können die Bewicklungen oder die einzelnen Anstriche in unterschiedlicher Länge ausgeführt sein, um die jeweils gewünschte Ortsabhängigkeit des elektrischen Widerstandes zu erreichen. Weiterhin können die einzelnen Lagen auch aus unterschiedlichen Materialien mit unterschiedlichen elektrischen Widerstandscharakteristiken realisiert werden.

Die Bänder bestehen üblicherweise aus einem elektrisch nicht leitfähigen Trägermaterial (z.B. Polyestervlies, Polyestergewebe oder Glasgewebe) und einem Reaktionsharz (beispielsweise epoxidierte Phenolnovolake, häufig mittels Dicyandiamin beschleunigt) in einem vorreagierten Stadium ("bi-Stage") das mit einem elektrisch (halb-)leitenden Füllstoff gefüllt ist.

Leitende bzw. halbleitende Lacke sind typischerweise lösemittelbasierte Systeme wie Phenolharze, welche wiederum mit leitenden bzw. halbleitenden oder halbleitend funktionalisierten Füllstoffen versehen sind.

Dabei wird für einen Außenglimmschutz beispielsweise häufig Graphit als Füllstoff verwendet. Für einen Endenglimmschutz wird beispielsweise Siliziumkarbid verwendet. Der resultierende elektrische Widerstand des Bandes wird hierbei unter anderem durch die mittlere Korngröße bestimmt.

Nachteiligerweise müssen oben genannte Bänder zur vollständigen Aushärtung etwa zwei Stunden bei ca. 165°C oder bis zu 12 Stunden bei 120°C ausgehärtet werden. Oben genannte Lacke müssen aufgrund ihres vergleichsweise hohen Lösungsmittelgehalts ebenfalls mehrere Stunden bis zu einer Weiterverarbeitung trocknen.

Da häufig einige Schichten übereinander hergestellt werden müssen, handelt es sich bei der Herstellung eines Außenglimmschutzes, und vor allem bei der Herstellung eines Endenglimmschutzes um einen sehr zeitaufwändigen und damit kostenintensiven Prozess.

Der Erfindung liegt die Aufgabe zugrunde, eine besonders rationelle Herstellung einer Glimmschutzschicht für eine elektrische Maschine zu ermöglichen.

Diese Aufgabe wird bezüglich eines - zur Herstellung einer Glimmschutzschicht verwendbaren - Glimmschutzwerkstoffs erfindungsgemäß gelöst durch die Merkmale des Anspruchs 1. Demnach umfasst der Glimmschutzwerkstoff ein (im Folgenden auch kurz als "Matrix" bezeichnetes) Matrixmaterial, das in einem Vorfertigungszustand fließfähig, d.h. dünnflüssig oder zähflüssig ist, und das in einer Aushärtungsreaktion zu einem Feststoff aushärtbar ist. Das Matrixmaterial kann dabei insbesondere einerseits im Wesentlichen aus Monomeren bestehen, welche sich in der Aushärtungsreaktion zu dem Feststoff verketten und/oder vernetzen. Alternativ kann das Matrixmaterial auch bereits aus teilweise vorvernetzten (bi-stage) Polymeren bestehen, welche sich dann wiederum in der Aushärtungsreaktion zu dem Feststoff vernetzen. Eine solche Aushärtungsreaktion kann dabei insbesondere durch eine Polymerisation, eine Polyaddition oder eine Polykondensation erfolgen.

Der Glimmschutzwerkstoff enthält weiterhin mindestens einen fotosensitiven Initiator, welcher durch elektromagnetische Strahlung eines vorgegebenen Wellenlängenbereichs (insbesondere durch ultraviolettes (UV) Licht) in einen reaktiven Zustand überführbar ist, in welchem er die Aushärtungsreaktion auslösen kann. Die Überführung in den reaktiven Zustand ist im Folgenden auch mit "Aktivierung" des Initiators bezeichnet. Dabei kann der Initiator in dem reaktiven Zustand insbesondere reaktive Spezies emittieren, welche dann die Aushärtungsreaktion auslösen. Alternativ kann er sich auch selbst in dem angeregten Zustand befinden, wodurch er die Aushärtungsreaktion selbst auslöst.

Zudem enthält der Glimmschutzwerkstoff mindestens einen partikulär (d.h. in Form von Partikeln, somit als Pulver) vorliegenden Füllstoff, der elektrisch leitfähig ist, also von Natur aus oder infolge einer entsprechenden Beschichtung und/oder Oberflächenbehandlung eine elektrische Leitfähigkeit aufweist. Der Füllstoff kann hierbei auch halb- oder schwachleitend sein.

Die elektrischen Eigenschaften des Glimmschutzwerkstoffes, insbesondere dessen elektrische Leitfähigkeit, sind dabei im Wesentlichen durch die Art, Menge und Korngrößenverteilung des Füllstoffs beeinflussbar.

Ein mit dem erfindungsgemäßen Glimmschutzwerkstoff hergestellter Endenglimmschutz hat vorzugsweise einen Flächenwiderstand zwischen 10⁴ Ω/cm² und 10¹⁴ Ω/cm² (vorzugsweise zwischen 10⁸ Ω/cm² und 10¹² Ω/cm²).

Ein mit dem erfindungsgemäßen Glimmschutzwerkstoff hergestellter Außenglimmschutz hat vorzugsweise einen Flächenwiderstand zwischen 3 Ω/cm² und 20 kΩ/cm² im trockenen Zustand und 3 kΩ/cm² und 200 kΩ/cm² im imprägnierten Zustand.

Kurzgefasst ist der erfindungsgemäße Glimmschutzwerkstoff im Wesentlichen durch ein mittels elektromagnetischer Strahlung aushärtbares Matrixmaterial gebildet, welches mit einem leit-oder halbleitfähigen, partikulären Füllstoff gefüllt ist.

Bei der zur Aushärtung einzusetzenden Strahlung kann es sich grundsätzlich um Infrarot-, Röntgen- und/oder Gamma-Strahlung handeln. In bevorzugter Ausführungsform ist der fotosensitive Initiator aber durch Bestrahlung mit UV-Strahlung in seinen reaktiven Zustand überführbar.

Da die Aushärtung des erfindungsgemäßen Glimmschutzwerkstoffs durch Bestrahlung erfolgt, kann der Glimmschutzwerkstoff vorteilhafterweise besonders schnell aushärten. Dabei ist der Glimmschutzwerkstoff trotz seines typischerweise vergleichsweise hohen Füllstoffgehalts mittels Strahlung aushärtbar.

Da bei einem typischen Fertigungsprozess beispielsweise eines mit einem Außen- oder Endenglimmschutz versehenen Leiterstabs das Aushärten des üblichen Glimmschutzlackes oder Imprägniermittels der langsamste Fertigungsschritt ist, wird durch eine Reduzierung der Aushärtezeit die gesamte Fertigung wesentlich beschleunigt.

Vorteilhafterweise kann durch die Aushärtung mittels Strahlung die Zeit bis zu einem nachfolgenden Fertigungsschritt auf beispielsweise etwa 180 Sekunden reduziert werden. Im Vergleich zu vorgenannten Trocknungszeiten von mehreren Stunden, kann somit der Zeitaufwand bis zur Fertigstellung des Endenglimmschutzes eines Generatorstabes von mehreren Tagen und Verteilung auf mehrere Betriebsarbeitsschichten auf wenige Minuten reduziert werden.

Vorteilhaft zeigt sich zudem, dass ein fotosensitiver Initiator sich im Normalfall ausschließlich durch elektromagnetische Strahlung eines vorgegebenen Wellenlängenbereichs in seinen reaktiven Zustand versetzen lässt, so dass eine Fehlaktivierung beispielsweise durch hohe Temperaturen vergleichsweise sicher auszuschließen ist.

In bevorzugten Ausführungsformen erfolgt die Aushärtungsreaktion durch einen radikalischen Vernetzungsmechanismus, bei welchem in einer Startreaktion ein Radikal gebildet wird, oder durch einen kationischen Vernetzungsmechanismus, bei welchem in der Startreaktion ein Kation gebildet wird. Als besonders vorteilhaft zeigt sich dabei ein kationischer Vernetzungsmechanismus, da hierbei im Gegensatz zur radikalischen Vernetzung keine Abbruchreaktion stattfindet, so dass nach einer anfänglichen Bestrahlung des Werkstoffs eine Aushärtung der Matrix auch im Schattenbereich der Füllstoffpartikel fortgeführt wird.

In einer besonders bevorzugten Ausführungsform enthält der Glimmschutzwerkstoff mindestens zwei unterschiedliche fotosensitive Initiatoren, wobei jeder Initiator bei einem im Vergleich zu den anderen Initiatoren unterschiedlichen Wellenlängenbereich der zur Aktivierung eingesetzten Strahlung in seinen jeweiligen reaktiven Zustand überführbar ist.

Die gleichzeitige Verwendung mehrerer Initiatoren ist insbesondere aufgrund des Umstandes vorteilhaft, dass einem fotosensitiven Initiator oft jeweils eine bestimmte Wellenlänge (genauer ein bestimmter, spektral schmaler Wellenlängenbereich) zuzuordnen ist, wobei der Initiator durch Strahlung aus diesem Wellenlängenbereich am effektivsten in seinen reaktiven Zustand überführbar ist. Dieser Wellenlängenbereich fällt dabei regelmäßig mit einem Absorptionsmaximum eines Absorptionsspektrums des zugehörigen Initiators zusammen.

Beispielsweise absorbiert der fotosensitive Initiator 2,4,6-Trimethylbenzoyldiphenylphosphinoxid Strahlung im UV-A Bereich stark mit einem Absorptionsmaximum bei ca. 370 nm, während er für Strahlung mit geringerer Wellenlänge nahezu durchlässig ist. Der fotosensitive Initiator Methyl-o-Benzoylbenzoat absorbiert dagegen im kürzer-welligen UV-Bereich.

Durch die vorgenannte Kombination zweier oder mehrerer Initiatoren, welche sich durch Bestrahlung bei unterschiedlichen Wellenlängen in ihren reaktiven Zustand versetzen lassen, wird somit besonders vorteilhaft eine Tiefendurchstrahlung und eine Tiefenaushärtung ermöglicht. Damit ist vorteilhafterweise eine Aushärtung von relativ dicken Werkstoffschichten von bis zu einem Millimeter möglich, wohingegen bei Verwendung eines einzelnen Initiators bei derartig großen Schichtdicken möglicherweise lediglich in einem oberflächennahen Bereich eine Aushärtung des Matrixmaterials erfolgen würde.

Dabei ist die Konzentration des reaktivsten Initiators insbesondere entsprechend gering gewählt, so dass eine einfallende Strahlung nicht gleich an der Oberfläche der Werkstoffschicht vollständig absorbiert wird.

Eine bevorzugte Initiatorkonzentration liegt bei einem Massenanteil von etwa 1% Initiator bezogen auf den fließfähigen Glimmschutzwerkstoff (wobei der Glimmschutzwerkstoff vorzugsweise lösungsmittelfrei formuliert ist und somit bei der Aushärtung einen nur sehr geringen Massenverlust erfährt). Dabei bezieht sich beim Einsatz mehrerer Initiatoren der Massenanteil auf die Summe der Einzelanteile der jeweiligen Initiatoren.

Die zur Aushärtung notwendige Bestrahlung bei unterschiedlichen Wellenlängen erfolgt insbesondere entweder nacheinander oder gleichzeitig. Beispielsweise erfolgt die Bestrahlung durch einen sogenannten F-Strahler (Strahler mit einem Eisen-Spektrum), G-Strahler (Strahler mit einem Gallium-Spektrum) oder H-Strahler (Strahler mit einem Quecksilber-Spektrum) oder durch Hintereinanderschalten mindestens zweier solcher Strahler.

Als bevorzugt in dem Glimmschutzwerkstoff enthaltene fotosensitive Initiatoren haben sich 2,4,6-Trimethylbenzoyldiphenylphosphinoxid (TPO), Methyl-o-benzoylbenzoat (MOBB) und/oder Bis-[4(diphenylsulfonium)-phenyl]sulfid-bis-hexafluoroantimonat herausgestellt; die Erfindung ist jedoch nicht auf diese Initiatoren beschränkt.

Vorzugsweise enthält der Glimmschutzwerkstoff mindestens einen Beschleuniger (auch: Synergist oder Katalysator), welcher die Aushärtungsreaktion beschleunigt.

In einer weiteren bevorzugten Ausführungsform enthält der Glimmschutzwerkstoff mindestens einen sogenannten "sekundären Beschleuniger". Hierbei handelt es sich um einen Beschleuniger der nicht auf die Matrix sondern auf den Initiator wirkt, indem er die Aktivierungswellenlänge des Initiators verändert. Der Beschleuniger beeinflusst hierzu den Initiator dahingehend, dass dieser durch Strahlung mit einer von seiner typischen Aktivierungswellenlänge abweichenden Wellenlänge in seinen reaktiven Zustand überführbar ist. Zusätzlich oder alternativ kann ein derartiger sekundärer Beschleuniger auch die Aktivierungsenergie zur Überführung des Initiators in seinen reaktiven Zustand herabsetzen.

Mittels eines solchen Synergists kann vorteilhafterweise die Aktivierung des Initiators bei einer von seiner typischen Aktivierungswellenlänge abweichenden Wellenlänge forciert werden, so dass insbesondere bei Kombination mehrerer Initiatoren vorteilhafterweise nahezu das gesamte UV-Spektrum zur Aushärtung effektiv genutzt werden kann.

In einer weiteren Ausführungsform ist in dem Glimmschutzwerkstoff zusätzlich zu dem mindestens einen fotosensitiven Initiator mindestens ein weiterer temperatursensitiver Initiator enthalten, welcher durch eine Temperaturerhöhung in seinen reaktiven Zustand überführbar ist. In dieser Ausführungsform ist der Glimmschutzwerkstoff vorteilhafterweise mit einer sogenannten "Dual Cure"-Option behaftet, d.h. die Aushärtungsreaktion kann wahlweise oder additiv sowohl durch Strahlung als auch durch eine Temperaturerhöhung ausgelöst werden.

Zusätzlich oder alternativ enthält der Glimmschutzwerkstoff als Additiv vorzugsweise eine Phosphorverbindung, insbesondere Diphenylkresylphosphat (vorzugsweise in Form des Produkts Disflamoll® DPK der Fa. Lanxess) oder Dimethylpropanphosphonat (vorzugsweise in Form des Produkts Levagard® DMPP der Fa. Lanxess). Durch Einsatz dieses Additivs wird vorteilhafterweise die Selbstverlöschung im Brandfall erhöht. Der Glimmschutzwerkstoff kann hierdurch vorteilhafterweise schwerentflammbar eingestellt werden, und somit "UL-94", "V-0" oder weitere Brennbarkeitseinschränkung und -norm erfüllen.

Zusätzlich oder alternativ kann der Glimmschutzwerkstoff mindestens ein weiteres Additiv zur Beeinflussung der Werkstoffeigenschaften enthalten. So kann durch geeignete Additive insbesondere vorteilhafterweise die Viskosität des Glimmschutzwerkstoffs eingestellt werden, so dass dieser wahlweise als sprühfähiger oder als streichfähiger Lack formulierbar ist. Hierdurch kann vorteilhafterweise im Idealfall sogar eine vollständige Lösemittelfreiheit des Glimmschutzwerkstoffs erreicht werden, wodurch sich der Glimmschutzwerkstoff als besonders gesundheits- und umweltfreundlich auszeichnet.

Als bevorzugte Matrixmaterialien haben sich Bisphenol-A-diglycidylether, Bisphenol-F-diglycidylether, 3,4-Epoxycyto-hexylmethol-3',4'-epoxy-cyclohexancarboxylat (EEC), Phenolnovolak, Acrylat, Polyester (insbesondere Polyesterimid), Urethan und/oder Enolether herausgestellt, wobei das Matrixmaterial auch aus einer Mischung dieser Stoffe bestehen kann. Die Erfindung ist zudem nicht auf den Einsatz dieser Materialien beschränkt.

Bei Einsatz eines urethanisierten Acrylats als Matrixmaterial wird vorteilhafterweise eine besonders gute Temperaturbeständigkeit des Werkstoffs erzielt. Insbesondere kann auf diese Weise eine Wärmebestandsklasse (WBI) bis zu 180° C erreicht werden. Zusätzlich wird eine gute Kratzfestigkeit erzielt.

Der in dem Glimmschutzwerkstoff enthaltene Füllstoff besteht in bevorzugten Ausführungsformen aus Siliziumkarbid-Partikeln, Graphit-Partikeln, Ruß (insbesondere Carbon Black) beschichteten Glimmer-Partikeln und/oder "Minatec"-Partikeln (Fa. Merck). Die Füllstoff-Partikel weisen bevorzugt einen mittleren Korndurchmesser 2 bis 50 μm, bevorzugt etwa 10 μm auf.

Im ausgehärteten Zustand weist der Glimmschutzwerkstoff in bevorzugter Zusammensetzung einen Füllstoffgehalt von etwa 50 bis 90, vorzugsweise etwa 80 Massenprozent auf.

Der vorgestellte Glimmschutzwerkstoff wird vorzugsweise zur Herstellung eines Außenglimmschutzes und/oder eines Endenglimmschutzes für eine elektrische Maschine verwendet. Dabei ist der enthaltene Füllstoff in an sich bekannter Weise an den jeweiligen Verwendungszweck angepasst. Vorzugsweise ist bei der Verwendung als AGS Graphit als Füllstoff enthalten, während bei der Verwendung als EGS insbesondere Siliziumkarbid verwendet wird.

Eine Verwendung des Glimmschutzwerkstoffs zur Herstellung einer Glimmschutzschicht ist jedoch auch in anderen Bereichen, in denen ein kontrolliert geführter Potentialabbau notwendig ist, beispielsweise bei einem Kabelendverschluss oder einer Kabeldurchführung, denkbar.

Der Glimmschutzwerkstoff wird vorzugsweise als Lack oder Imprägniermittel zur Imprägnierung eines Vlieses verwendet, wobei wiederum je nach Verwendungszweck die Viskosität und das Matrixmaterial geeignet gewählt sind.

Gegenstand der Erfindung ist ferner eine elektrische Maschine, insbesondere ein leistungsstarker Motor oder Generator, welcher einen Leiterstab (insbesondere einer Ständerwicklung) umfasst, dessen Hauptisolierschicht mit einer Glimmschutzschicht versehen ist. Die Glimmschutzschicht ist dabei erfindungsgemäß durch Auftrag des vorstehend beschriebenen, erfindungsgemäßen Glimmschutzwerkstoffes sowie durch Aushärtung des Werkstoffes mittels elektromagnetischer Strahlung hergestellt. In seinem Rohzustand liegt der Glimmschutzwerkstoff dabei wiederum insbesondere als Lack oder als Imprägniermittel vor.

Nachfolgend werden Ausführungsbeispiele der Erfindung anhand einer Zeichnung näher erläutert. Darin zeigen:
- FIG 1: in einer grob schematischen Darstellung einen Ausschnitt aus einer elektrischen Maschine mit einem isolierten Leiterstab, der einen Teil einer Statorwicklung bildet, wobei der Leiterstab mit einer aus einem Glimmschutzwerkstoff bestehenden Glimmschutzschicht versehen ist,
- FIG 2: in einem schematischen Querschnitt einen aus der Glimmschutzschicht gebildeten Außen- oder Endenglimmschutz in einem Vorfertigungszustand vor dem Aushärten des Glimmschutzwerkstoffs, und
- FIG 3: in Darstellung gemäß FIG 2 den Außen- bzw. Endenglimmschutz nach dem Aushärten des Glimmschutzwerkstoffs.

Einander entsprechende Teile und Größen sind in allen Figuren stets mit den gleichen Bezugszeichen versehen.

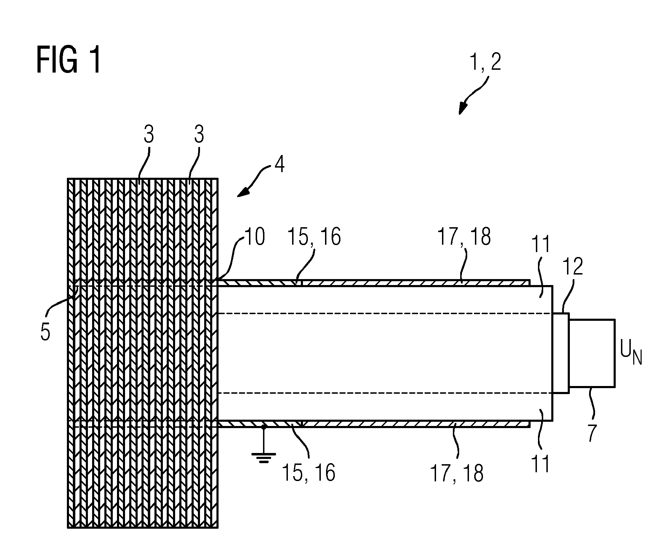

FIG 1 zeigt in einer stark vereinfachten Darstellung einen Ausschnitt aus einer elektrischen Maschine 1, hier eines Drehstrom-Turbogenerators. Die Maschine 1 umfasst einen Stator 2 (auch als Ständer bezeichnet), in dem ein (nicht explizit dargestellter) Rotor drehbar gelagert ist.

Der Stator 2 umfasst ein aus einer Vielzahl von aneinander gereihten, und untereinander isolierten Blechplatten 3 gebildetes (Stator-)Blechpaket 4. In das Blechpaket 4 sind in an sich bekannter Weise quer zur Flächenausdehnung der Blechplatten 3 mehrere durchgehende (Längs-)Nuten 5 eingebracht, von denen in FIG 1 aus Gründen der Vereinfachung lediglich eine dargestellt ist. In jeder Nut 5 liegt ein Leiterstab 7 ein. Jeder Leiterstab 7 ist (in nicht explizit dargestellter Weise) wiederum aus mehreren gegeneinander isolierten Kupfer-Teilleitern gebildet, die zur Bildung eines sogenannten Roebelstabs miteinander verdrillt sind.

An einem Nutaustritt 10 ragt der Leiterstab 7 aus der Nut 5 heraus.

Zur Isolierung des unter Betriebsbedingungen mit einer elektrischen Hochspannung U_{N} beaufschlagten Leiterstabs 7 gegenüber dem geerdeten Blechpaket 4 ist dieser umfänglich zur Ausbildung einer Hauptisolierschicht 11 mit einem in einem Vakuumtränkverfahren getränkten Feinglimmerglasgewebeband umwickelt.

Um die Bildung von Potentialspitzen zu vermeiden, und somit die Entstehung von Teilentladungen zu reduzieren, ist der Leiterstab 7 innerhalb der Hauptisolierschicht 11 mit einer durch ein Leitvlies gebildeten Innenpotentialsteuerung 12 versehen. Zudem ist die Hauptisolierschicht 11 zumindest innerhalb des Blechpakets 4 außenseitig mit einer elektrisch leitfähigen Schicht 15 umgeben, die als Außenglimmschutz 16 dient. Der Außenglimmschutz 16 ist etwas über den Nutaustritt 10 hinaus fortgeführt, steht also geringfügig aus dem Blechpaket 4 hervor.

Um die Entstehung einer Gleitanordnung zu vermeiden, ist in der Verlängerung des Außenglimmschutzes 16 ein Endenglimmschutz 17 auf die Hauptisolierschicht 11 aufgebracht, welcher durch eine halbleitfähige Schicht 18 gebildet ist, deren Oberflächenwiderstand in Axialrichtung des Leiterstabs 7 ortsabhängig variiert.

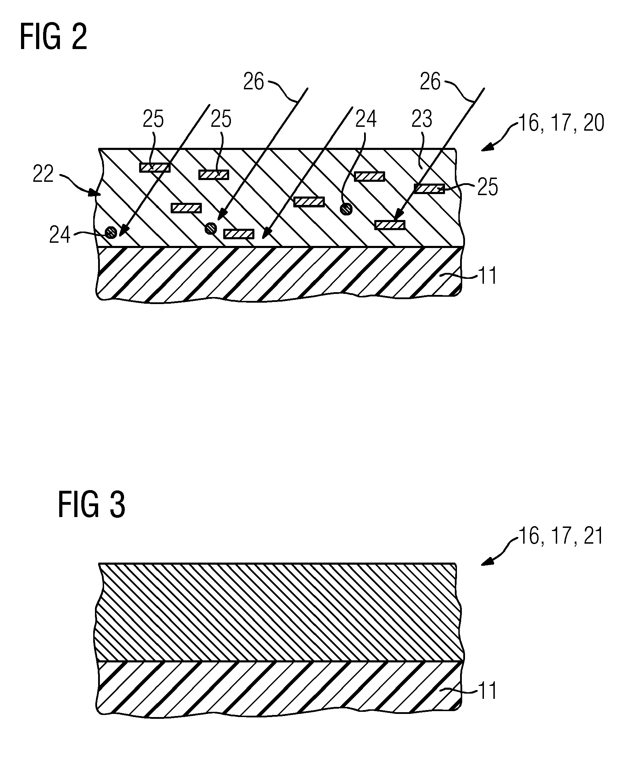

Anhand von FIG 2 und FIG 3 ist die Herstellung des Außenglimmschutzes 16 und des Endenglimmschutzes 17 schematisch erläutert. Dabei ist der Außenglimmschutz 16 bzw. Endenglimmschutz 17 in FIG 2 in einem Vorfertigungszustand 20 und in FIG 3 in einem Endzustand 21 dargestellt.

Zur Herstellung des Vorfertigungszustands 20 wird gemäß FIG 2 ein Glimmschutzwerkstoff 22 in einem zunächst zähflüssigen Zustand auf den Umfang der Hauptisolierungsschicht 11 aufgestrichen. Der Glimmschutzwerkstoff 22 enthält ein Matrixmaterial 23, einen fotosensitiven Initiator 24 (hier schematisch als Punkte dargestellt) sowie einen Füllstoff 25, welcher in Form von Partikeln, d.h. Körnern (hier schematisch als Balken dargestellt), vorliegt.

Je nach Anwendungsfall variiert der eingesetzte Füllstoff 25. Zur Herstellung des Außenglimmschutzes 16 wird insbesondere Graphit aufgrund dessen guter Leitfähigkeit als Füllstoff 25 eingesetzt. Für die Herstellung des Endenglimmschutzes 17 wird vorzugsweise Siliziumkarbid verwendet.

Zur Aushärtung wird der Glimmschutzwerkstoff 21 mit elektromagnetischer Strahlung 26 bestrahlt, wodurch der Initiator 24 in einen reaktiven Zustand überführt wird, in welchem er eine Aushärtung des Matrixmaterials 23 auslöst. Dabei ist der eingesetzte fotosensitive Initiator derart gewählt, dass die teilweise durch Matrixmaterial 23 und Füllstoff 25 absorbierte bzw. gestreute Strahlung 26 auch in der Nähe der Hauptisolierschicht 11 noch ausreicht, den Initiator 24 zu aktivieren und eine Vernetzungsreaktion auszulösen. Somit wird (wie in FIG 3 gezeigt) trotz eines hohen Füllstoffgehalts von bis etwa 70 Massenprozent eine Durchhärtung des gesamten Glimmschutzwerkstoffs 21 erreicht.

Zur Herstellung eines Endenglimmschutzes 17 oder eines Außenglimmschutzes 16 kann dabei entweder der jeweils entsprechend gefüllte viskose Glimmschutzwerkstoff 22 direkt auf die Hauptisolierschicht 11 aufgetragen werden. Alternativ kann die Hauptisolierschicht 11 auch zunächst mit einem tränkbaren Gewebeband umwickelt werden, welches anschließend mit dem Glimmschutzwerkstoff 22 getränkt wird.

In einer ersten Ausführungsvariante, die insbesondere für die Herstellung eines Endenglimmschutzes vorteilhaft verwendbar ist, enthält der Glimmschutzwerkstoff 21
● 24 Massen-% ungesättigtes Polyesterimid als Matrixmaterial 22,
● ca. 1 Massen-% Trimethylbenzoyldiphenylphosphinoxid (TPO) als fotosensitiven Initiator 23,und
● 75 Massen-% Siliziumkarbid-Partikel des Feinheitsgrades F600 (mit Korngrößen im Bereich von ca. 3 - 19 μm) als Füllstoff 24.

Zur Herstellung eines Endenglimmschutzes 17 wird eine ca. 100 μm dicke Schicht durch Lackierung aufgebracht und anschließend mit UV-Licht eines G-Strahlers für 180 s bestrahlt.

Nach dem vollständigen Aushärten können auf dieselbe Weise weitere Schichten aufgebracht werden.

In einer zweiten Ausführungsvariante, die insbesondere für die Herstellung eines Außenglimmschutzes 16 vorteihaft verwendbar ist, enthält der Glimmschutzwerkstoff 21
● 29,7 Massen-% Bisphenol-F-diglycidylether als Matrixmaterial 22,
● ca. 0,3 Massen-% Bis-[4(diphenylsulfonium)-phenyl]-sulfid-bis-hexafluoroantimonat als kationischen fotosensitiven Initiator 23,
● 70 Massen-% Graphit-Partikel (in Form von "Carbon Black") als Füllstoff 24.

In einer dritten Ausführungsvariante enthält der Glimmschutzwerkstoff 21
● 29 Massen-% Bisphenol-F-diglycidylether als Matrixmaterial 22,
● ca. 0,3 Massen-% TPO als fotosensitiven Initiator 23,
● ca. 0,7 Massen-% des kommerziell unter dem Markennamen "ADEKA OPTON CP-77" (Fa. Adeka) erhältlichen kationischen thermischen Initiators 23, und
● 70 Massen-% Graphit-Partikel (in Form von "Carbon Black") als Füllstoff 24.

Bei dieser Ausführungsvariante kann die Aushärtungsreaktion sowohl durch Bestrahlung mit ultravioletter Strahlung als auch durch Erhitzung für 1,5 Stunden auf 80 °C ausgelöst werden.

Optional ist dem Glimmschutzwerkstoff 21 in einer der vorstehend genannten Ausführungsvarianten ca. 0,1 Massen-% (Mono-)Ethanolamin als Additiv zugesetzt, das der Bildung von reaktiven Spezies bei der Alterung des Matrixmaterials 22 entgegenwirkt.

Prozentangaben beziehen sich stets auf die Masse der Gesamtformulierung.

Zusätzlich oder alternativ zu den vorstehend genannten Stoffen können als Matrixmaterial 22 des Glimmschutzwerkstoffs 21 insbesondere eingesetzt werden:
● Bisphenol-A-diglycidylether (BADGE),
● Bisphenol-F-diglycidylether (BFDGE),
● 3,4-Epoxycyclohexylmethyl-3',4'-epoxycyclohexancarboxylat (ECC),
● Phenolnovolak,
● ein Acrylat,
● ein Urethan und/oder
● ein Enolether.

## Patentansprüche

1. Glimmschutzwerkstoff (22) zur Herstellung einer Glimmschutzschicht für eine elektrische Maschine
- welcher ein zunächst fließfähiges Matrixmaterial (22) enthält, das in einer Aushärtungsreaktion zu einem Feststoff aushärtbar ist,
- welcher mindestens einen fotosensitiven Initiator (24) enthält, der durch elektromagnetische Strahlung (26) in einen die Aushärtungsreaktion auslösenden reaktiven Zustand überführbar ist, und
- welcher mindestens einen partikulär vorliegenden, elektrisch leitenden Füllstoff (25) enthält.

2. Glimmschutzwerkstoff (22) nach Anspruch 1,
wobei der fotosensitive Initiator (24) durch den Einsatz von ultravioletter Strahlung (26) in seinen reaktiven Zustand überführbar ist.

3. Glimmschutzwerkstoff (22) nach Anspruch 1 oder 2,
bei dem das Matrixmaterial in einem radikalischen oder kationischen Vernetzungsmechanismus aushärtbar ist.

4. Glimmschutzwerkstoff (22) nach einem der Ansprüche 1 bis 3,
welcher mindestens zwei fotosensitive Initiatoren (24) enthält, wobei jeder Initiator (24) bei einem zu den anderen Initiatoren (24) unterschiedlichen Wellenlängenbereich der zur Aktivierung eingesetzten Strahlung (26) in seinen jeweiligen reaktiven Zustand überführbar ist.

5. Glimmschutzwerkstoff (22) nach einem der Ansprüche 1 bis 4,
wobei der Initiator (24)
● 2,4,6-Trimethylbenzoyldiphenylphosphinoxid (TPO), Methyl-o-benzoylbenzoat (MOBB) und/oder
● Bis-[4(diphenylsulfonium)phenyl]sulfid-bis-hexafluoroantimonat)
enthält.

6. Glimmschutzwerkstoff (22) nach einem der Ansprüche 1 bis 4,
wobei der Initiator (24) einen Massenanteil von etwa 1% im fließfähigen Zustand des Glimmschutzwerkstoffs aufweist.

7. Glimmschutzwerkstoff (22) nach einem der Ansprüche 1 bis 5,
welcher mindestens einen Beschleuniger enthält, der die Aushärtungsreaktion beschleunigt.

8. Glimmschutzwerkstoff (22) nach einem der Ansprüche 1 bis 6,
welcher mindestens einen Beschleuniger enthält, der eine Aktivierungswellenlänge des Initiators (24) verändert.

9. Glimmschutzwerkstoff (22) nach einem der Ansprüche 1 bis 7,
welcher mindestens einen weiteren temperatursensitiven Initiator enthält, der durch eine Temperaturerhöhung in seinen reaktiven Zustand überführbar ist.

10. Glimmschutzwerkstoff (22) nach einem der Ansprüche 1 bis 8,
welcher als Additiv eine Phosphorverbindung enthält.

11. Glimmschutzwerkstoff (22) nach einem der Ansprüche 1 bis 9,
wobei das Matrixmaterial (23)
● Bisphenol-A-diglycidylether,
● Bisphenol-F-diglycidylether,
● 3,4-Epoxycyclohexylmethyl-3',4'-epoxy-cyclohexancarboxy-lat,
● Phenolnovolak,
● ein Acrylat,
● ein Urethan und/oder
● ein Enolether ist.

12. Glimmschutzwerkstoff (22) nach einem der Ansprüche 1 bis 10,
wobei der Füllstoff (25)
● Siliziumkarbid-Partikel,
● Graphit-Partikel,
● Ruß,
● beschichtete Glimmer-Partikel und/oder
● "Minatec"-Partikeln enthält.

13. Glimmschutzwerkstoff (22) nach einem der Ansprüche 1 bis 11,
wobei die Partikel des Füllstoffs (25) einen mittleren Korndurchmesser von 2 bis 50 μm, bevorzugt etwa 10 μm aufweisen.

14. Glimmschutzwerkstoff (22) nach einem der Ansprüche 1 bis 12,
welcher in seinem ausgehärteten Zustand einen Füllstoffgehalt von etwa 50 bis 90 Massen-%, vorzugsweise etwa 80 Massen-% aufweist.

15. Verwendung des Glimmschutzwerkstoffes (22) gemäß einem der Ansprüche 1 bis 13 zur Herstellung eines Außenglimmschutzes (16) und/oder eines Endenglimmschutzes (17) für eine elektrische Maschine (1).

16. Verwendung des Glimmschutzwerkstoffes (22) gemäß einem der Ansprüche 1 bis 13 als Lack oder als Imprägniermittel.

17. Elektrische Maschine (1) mit einem Leiterstab (7), dessen Hauptisolierschicht (11) mit einer Glimmschutzschicht (16, 17) versehen ist, welche durch Auftrag und Aushärtung des Glimmschutzwerkstoffes (22) gemäß einem der Ansprüche 1 bis 13 hergestellt ist.
